Europäisches Patentamt

**European Patent Office**

Office européen des brevets

(19)

(11) Numéro de publication: **0 108 010**
**A1**

# (12) DEMANDE DE BREVET EUROPEEN

(21) Numéro de dépôt: **83402040.6**

(22) Date de dépôt: **21.10.83**

(51) Int. Cl.³: **H 03 H 7/42**
**H 01 F 19/04**

(30) Priorité: **29.10.82 FR 8218237**

(43) Date de publication de la demande:
**09.05.84 Bulletin 84/19**

(84) Etats contractants désignés:
**CH DE GB LI NL**

(71) Demandeur: **THOMSON-CSF**
**173, Boulevard Haussmann**
**F-75379 Paris Cedex 08(FR)**

(72) Inventeur: **Lefebvre-Albaret, Claude**
**Thomson-CSF SCPI 173, bld Haussmann**
**F-75379 Paris Cedex 08(FR)**

(74) Mandataire: **Courtellemont, Alain et al,**
**THOMSON-CSF SCPI 173, Bld Haussmann**
**F-75379 Paris Cedex 08(FR)**

(54) **Transformateur d'émission, à large bande, pour télécommunications H.F.**

(57) Le transformateur est un transformateur à air dont le bobinage (10-12, 11-13) est choisi aussi long que possible pour favoriser les fréquences basses tout en laissant passer la fréquence supérieure de la bande de fréquences de travail. Pour améliorer les caractéristiques du transformateur aux fréquences basses un circuit magnétique ouvert, constitué de barreaux de ferrite (b1, b4) parallèles entre eux, est utilisé.

Application, en particulier, aux télécommunications H.F. dans la bande 2-30 MHz.

Fig.3

EP 0 108 010 A1

1

## Transformateur d'émission, à large bande,
## pour télécommunications H.F.

La présente invention se rapporte aux transformateurs d'émission, à large bande, utilisés pour les télécommunications H.F., c'est-à-dire à des transformateurs d'une puissance le plus souvent supérieure à 300 watts et dont la bande des fréquences de travail va de 2 MHz à environ 30 MHz.

Il est connu de réaliser des transformateurs dont le circuit magnétique est constitué de quatre à six blocs, en forme de parallélépipèdes, disposés de manière à constituer un circuit magnétique fermé. Les blocs sont des blocs en ferrite de qualité H.F., sélectionnés après cuisson au four et usinés avec une grande précision. De tels transformateurs sont de relativement petite taille et peuvent être conçus pour constituer des transformateurs d'émission tels qu'ils ont été définis au paragraphe précédent.

Du fait de l'utilisation de ces blocs de ferrite qui constituent des circuits magnétiques courts et du fait de la faible distance entre les spires de ces transformateurs, la densité volumique de puissance est importante, ce qui conduit à placer ces transformateurs connus dans un bain d'huile.

Il est peu rentable, dans des pays tels que la France, de mettre en oeuvre une production de ces blocs de ferrite étant donné les faibles quantités à réaliser et les difficultés de fabrication. C'est pourquoi, actuellement, les fabricants de ces transformateurs ne trouvent qu'aux Etats-Unis d'Amérique les blocs de ferrite dont ils ont besoin.

La présente invention a pour but d'éviter les problèmes liés aux transformateurs à bain d'huile et de permettre la réalisation de transformateurs du type indiqué au début de cette description sans avoir besoin des blocs de ferrite dont il a été question ci-avant et sans nécessiter d'autres éléments dont l'approvisionnement pourrait poser des problèmes.

Ceci est obtenu par la combinaison d'une réalisation de type transformateur à air conduisant à une faible densité volumique de puissance et d'un circuit magnétique de type ouvert, constitué par un ensemble de barreaux de ferrite parallèles entre eux, et par le fait que la longueur du bobinage du transformateur est sensiblement la longueur à ne pas dépasser pour permettre un fonctionnement à la fréquence supérieure de la bande de fréquences à couvrir.

La présente invention sera mieux comprise et d'autres caractéristiques apparaîtront à l'aide de la description ci-après et des figures s'y rapportant qui représentent :

- les figures 1 et 2 deux schémas de principe relatifs à un transformateur selon l'invention,

- la figure 3 une vue d'un transformateur selon l'invention correspondant, aux schémas de figures 1 et 2,

- la figure 4, le schéma de principe relatif à un autre transformateur selon l'invention.

Sur les différentes figures les éléments correspondants sont désignés par les mêmes repères.

Les transformateurs selon l'invention sont des transformateurs à air conçus, le plus généralement, pour être refroidis par convection naturelle en circuit fermé ; le choix de ce type de transformateurs a été guidé par le désir de ne pas avoir à faire face aux problèmes de l'huile avec, en particulier, les problèmes d'étanchéité et, éventuellement, l'utilisation de fonderies poreuses.

Les transformateurs qui vont être décrits ci-après ont été étudiés pour avoir des longueurs de bobinage aussi grandes que possible tout en permettant néanmoins de travailler jusqu'à des fréquences de l'ordre de 30 MHz. Comme il s'avère qu'un tel transformateur ne peut travailler à des fréquences inférieures à 5 MHz sans un circuit magnétique, les transformateurs ci-après comportent un circuit magnétique prévu pour améliorer leurs performances aux fréquences basses jusqu'à leur permettre de travailler à 2 MHz ; ceci est obtenu dans les réalisations ci-après au moyen de circuits magnétiques ouverts, de barreaux de ferrite de fabrication standard, moulés mais non usinés, et de qualité H.F.

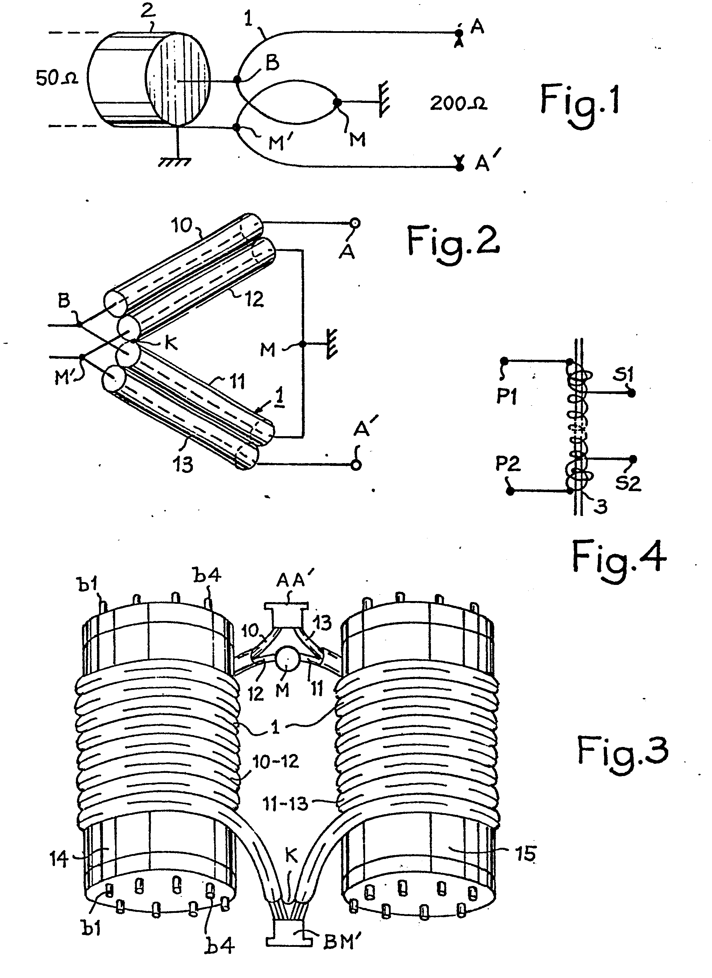

La figure 1 est un schéma de principe d'un symétriseur 1 (balun dans la littérature anglo-saxonne) destiné à permettre le passage de l'impédance caractéristique de 50 ohms d'un câble coaxial, 2, à une impédance caractéristique de 200 ohms. Le câble coaxial 2 dont le conducteur extérieur est à la masse constitue une ligne d'alimentation dissymétrique par rapport à la masse et est relié, par ses conducteurs intérieur et extérieur, respectivement aux bornes B et M' du circuit primaire du symétriseur 1. Le symétriseur 1 est un autotransformateur schématisé par un conducteur formant deux spires, dont le point milieu, M, est à la masse et dont les extrémités A et A' constituent les bornes du circuit secondaire. Les bornes B et M' sont respectivement situées au milieu des deux spires du symétriseur.

Comme le montre la figure 2, le symétriseur 1 de la figure 1 peut être réalisé au moyen de tronçons, 10-13, de câble coxial, branchés comme indiqué ci-après :

- les conducteurs intérieurs des tronçons 10 à 13 sont respectivement connectés entre les bornes A et B, B et M, M' et M, M' et A'.

- les conducteurs extérieurs des tronçons 10 et 12 d'une part et 11 et 13 d'autre part sont accolés et sont réunis tous les quatre, à l'une de leurs extrémités, par une liaison électrique K.

Ainsi réalisé, le bobinage du symétriseur 1 est constitué par les conducteurs intérieurs de câbles 10, 11, 12 et 13 branchés en série dans cet ordre.

Une réalisation du transformateur selon les figures 1 et 2 est donnée à la figure 3. Cette figure montre que les câbles accolés 10-12 et 11-13 sont placés sous une même gaine plastique et sont enroulés respectivement sur deux bobines creuses 14 et 15 constituées chacune par un cylindre fermé à chacune de ses extrémités par un couvercle percé de huit trous. Ces bobines sont réalisées en polytétrafluoroéthylène (plus connu sous la marque déposée téflon) et ont une longueur de 250 mm pour un diamètre de 150 mm. Les câbles accolés 10-12 et 11-13 sont enroulés pour former sensiblement huit spires autour de leur bobine. Comme il resort de ce qui a été indiqué plus avant, le nombre de spires a été choisi aussi grand que possible pour permettre un fonctionnement à des fréquences relativement basses tout en autorisant également un fonctionnement à 30 MHz. Huit barreaux de ferrite, tels que b1, b4, sont disposés dans chacune des bobines 14 et 15, parallèlement au grand axe non représenté de ces bobines, en passant par les trous percés à cet effet dans les couvercles d'extrémité des bobines. Ces barreaux sont des barreaux cylindriques d'une longueur de 300 mm et d'un diamètre de 10 mm ; ils sont commercialisés par la société française L.Ç.C - C.I.C.E qui les fabrique en une poudre de ferrite dont la référence est H30. Grâce à ces barreaux de ferrite qui constituent, pour chaque bobine, un circuit magnétique de type ouvert, les caractéristiques du symétriseur sont améliorées aux fréquences basses de manière à couvrir une bande de fréquences allant jusqu'à 2 MHz.

Les liaisons électriques des bobines 14, 15 de la figure 3 sont réalisées à l'aide d'une borne de masse, M, et de deux prises coaxiales AA' et BM' ; cette borne de masse et ces prises sont désignées par les repères des bornes auxquelles elles correspondent dans les figures 1 et 2. Sur la figure 3 apparaît également la liaison K, réalisée par fil métallique, entre les conducteurs extérieurs des câbles 10-12 et 11-13.

Le câble coaxial dont les tronçons sont réunis par paires, 10-12, 11-13, sous une même gaine plastique, est un câble dont le conducteur intérieur, l'isolant et le conducteur extérieur ont respectivement un diamètre de 2 mm, 7,8 mm et 8 mm. Le symétriseur ainsi réalisé est prévu pour une puissance normale d'utilisation de 10 kW.

Le schéma de principe selon la figure 4 est relatif à un autre exemple de transformateur selon l'invention. Ce transformateur, 3, est un autotransformateur qui comporte, entre les bornes P1 P2 de son circuit primaire, 13 spires et, entre les bornes S1, S2 de son circuit secondaire, 16 spires c'est-à-dire les 13 spires communes avec le circuit primaire et, de part et d'autre de ces 13 spires, une spire et demie ; ces deux fois une spire et demie sont, comme le montre la figure 4, bobinées non pas dans le prolongement des 13 spires mais par dessus les 13 spires afin d'être traversées par le maximum du champ créé par le circuit primaire ; en effet, dans la réalisation de cet autotransformateur, comme dans la réalisation selon la figure 3, le circuit magnétique est un circuit magnétique ouvert, formé de huit barreaux de ferrite et ces barreaux sont identiques à ceux décrits à l'aide de la figure 3. La bobine unique servant de support aux spires et aux barreaux est une bobine semblable à celle du symétriseur de la figure 3 mais de longueur réduite à 160 mm, ce qui fait que les barreaux de ferrite dépassent de 70 mm de part et d'autre de la bobine. Une encoche de trois millimètres de profondeur, tracée en hélice sur la bobine avec un pas égal à 5 mm, sert au maintien des 13 spires du circuit primaire ; ces spires sont constituées par un fil nu de 3 mm de diamètre. Quant aux deux fois une spire et demie relatives au circuit secondaire de l'autotransformateur, elles sont réalisées en fil isolé dont le diamètre du conducteur est de 2 mm; ces spires sont bobinées sur huit barres isolantes, parallèles au grand axe de la bobine et régulièrement disposées autour de la bobine à laquelle elles sont fixées par des vis ; des encoches pratiquées dans les barres isolantes déterminent la position des deux fois une spire et demie.

·L'autotransformateur, 3, qui vient d'être décrit à l'aide de la figure 4 fonctionne dans la bande de fréquences allant de 2 à 30 MHz avec une puissance normale d'utilisation de 10 kW et est destiné à permettre le passage d'une impédance de 200 ohms à une impédance de 300 ohms.

La présente invention n'est pas limitée aux exemples décrits ; elle s'applique aussi bien aux autotransformateurs qu'aux transformateurs à circuit primaire et secondaire séparés ; elle s'applique, également au cas où le nombre des barreaux de ferrite du circuit magnétique est différent de huit et en particulier au cas où ce nombre est réduit à 2, étant entendu que, pour ce qui est du problème de la dissipation de calories, il est préférable, à volume égal de ferrite, de prendre plusieurs barreaux. L'invention s'applique, en particulier, à la réalisation de tous les transformateurs d'émission pour télécommunication H.F. à moins que ne se posent des problèmes de place ou de poids, mais c'est rarement le cas. Il est d'ailleurs à remarquer que les transformateurs selon l'invention peuvent être refroidis par air forcé ce qui, évidemment, permet, à puissance égale, de réduire leur poids et leur volume.

6

## REVENDICATIONS

1. Transformateur d'émission, pour télécommunications H.F., destiné à fonctionner dans une large bande de fréquences prédéterminée, caractérisé par la combinaison d'une réalisation de type transformateur à air conduisant à une faible densité volumique de puissance et d'un circuit magnétique de type ouvert, constitué par un ensemble de barreaux de ferrite (b1, b4) parallèles entre eux, et par le fait que la longueur de son bobinage est sensiblement la longueur maximale compatible avec un fonctionnement à la fréquence supérieure de la bande prédéterminée.

2. Transformateur selon la revendication 1, caractérisé en ce que le support de son bobinage, son bobinage et son circuit magnétique forment au moins un ensemble comportant une bobine (14, 15) isolante, cylindrique, creuse, un conducteur (10-12, 11-13) enroulé en spires sur la bobine, sensiblement perpendiculairement au grand axe de la bobine, et au moins un barreau de ferrite (b1, b4) qui traverse la bobine parallèlement au grand axe de la bobine.

3. Transformateur selon la revendication 2, destiné au passage d'une impédance Z à une impédance 4Z, caractérisé en ce qu'il comporte deux ensembles (14-10-12-b1-b4, 15-11-13), en ce que la partie du bobinage enroulée sur chacune des bobines des deux ensembles est constituée par une paire de tronçons accolés (10-12, 11-13) d'un câble coaxial d'impédance caractéristique égale à Z, les conducteurs intérieurs des quatre tonçons étant connectés en série et la connexion en série se faisant en prenant alternativement un tronçon relatif à l'un des ensembles et un tronçon relatif à l'autre des ensembles.

Fig.1

Fig.2

Fig.4

Fig.3

## Office européen des brevets

### RAPPORT DE RECHERCHE EUROPEÉNNE

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl. ³) |
|---|---|---|---|
| A | DE-A-1 207 980  (AMALGAMATED WIRELESS AUSTRALASIA LTD.) * En entier * | 1-3 | H 03 H   7/42 H 01 F  19/04 |
| A | DE-A-1 516 030  (TELEFUNKEN) * En entier * | 1 | |
| A | FR-A-1 231 183 (THOMSON-HOUSTON) * En entier * | 1,3 | |

**DOMAINES TECHNIQUES RECHERCHES (Int. Cl. ³)**

H 03 H
H 01 F

Le présent rapport de recherche a été établi pour toutes les revendications

| Lieu de la recherche LA HAYE | Date d'achèvement de la recherche 06-02-1984 | Examinateur COPPIETERS C. |
|---|---|---|

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

OEB Form 1503. 03.82